# FASCICULE DE BREVET EUROPEEN

(11) **EP 3 470 871 B1**
(45) Date de publication et mention de la délivrance du brevet: **01.12.2021**
(21) Numéro de dépôt: 18199348.6
(22) Date de dépôt: 09.10.2018
(51) Int. Cl.: G01S 7/02, G01S 7/292, G01R 23/16

(54) **PROCÉDÉ DE DÉTECTION DE SIGNAUX RADAR**
RADARSIGNAL-DETEKTIONSVERFAHREN
METHOD FOR DETECTING RADAR SIGNALS

(30) Priorité: 10.10.2017 FR 1759454
(43) Date de publication de la demande: 17.04.2019
(73) Titulaire: Avantix, 13794 Aix-en-Provence (FR)
(72) Inventeur: TENEZE, Bernard, 13640 La Roque d'Antheron (FR)
(74) Mandataire: IPAZ

(56) Documents cités:
- CN-A- 101 504 638
- US-A1- 2001 040 525
- US-A1- 2014 253 361
- CHI-HAO CHENG ET AL: "Electronic Warfare Receiver with Multiple FFT Frame Sizes", IEEE TRANSACTIONS ON AEROSPACE AND ELECTRONIC SYSTEMS, IEEE SERVICE CENTER, PISCATAWAY, NJ, US, vol. 48, no. 4, 1 octobre 2012 (2012-10-01), pages 3318-3330, XP011467243, ISSN: 0018-9251, DOI: 10.1109/TAES.2012.6324709

## Description

### DOMAINE TECHNIQUE DE L'INVENTION

La présente invention se rapporte au domaine du traitement et de la détection du signal et/ou d'image, plus spécifiquement l'invention concerne un procédé de traitement de signaux ou d'impulsions radars.

### ARRIERE-PLAN TECHNOLOGIQUE DE L'INVENTION

Le traitement de signaux radar comprend un ensemble de techniques et méthodes d'analyse mise en œuvre de la réception des signaux à l'interprétation des informations contenues dans lesdits signaux. Une bonne interprétation desdites informations dépend donc, en partie, des méthodes appliquées pour le traitement desdits signaux, en particulier la méthode de la transformée de Fourier rapide (FFT).

Il existe de nombreux dispositifs et algorithmes permettant de mettre en œuvre le calcul de FFT pour la détection de signaux radar.

Néanmoins, ces dispositifs et/ou algorithmes ne sont souvent pas adaptés à la grande variété de signaux pouvant être réceptionnés par les radars et, par conséquent moins efficace dans la détection en temps réel par exemple d'une cible ou d'un objet.

L'état de la technique est par exemple connu de par « Electronic Warefare Receiver with Multiple EFT Frame Sizes », de Hi-Hao Cheng et al., IEEE Transactions on Aerospace and Electronic Systems, vol. 48, no. 4 (pages 3318-3330) et de US 2014/253361 A1.

### DESCRIPTION GENERALE DE L'INVENTION

La présente invention est définie dans les revendications indépendantes. Des modes de réalisation préférés sont définis dans les revendications dépendantes.

La présente invention a pour but de pallier certains inconvénients de l'art antérieur en proposant une méthode de traitement en temps réel de signaux radars.

Ce but est atteint par un procédé de traitement de signaux radar dans un système de détection comprenant au moins une architecture informatique comportant au moins une mémoire pour le stockage d'au moins un ensemble de programmes et/ou de données relatives signaux, au moins un processeur pour l'exécution desdits programmes afin de mettre en œuvre ledit procédé comprenant au moins:
- une première étape (E1) de numérisation des signaux radar au moyen d'un dispositif de numérisation;
- une seconde étape (E2) de génération de spectres à partir des signaux numérisés, obtenus dans la première étape (E1), via un calcul FFT;
ledit procédé étant caractérisé en ce que le calcul de FFT de l'étape de génération de spectres (E2) comprend au moins un traitement multi-FFT comportant au moins:
- le calcul de FFT (E20) simultané de différentes tailles avec sélection automatique desdites tailles via un algorithme de sélection parmi les tailles mémorisées;
- la sélection en temps réel de signaux (E21) dans l'ensemble des spectres résultants des différents calculs de FFT, effectuée via un algorithme de sélection.

Selon une autre particularité, le calcul de FFT (E20) de différentes tailles avec sélection automatique des tailles comprend l'exécution simultanée de différents sous-programmes comportant chacun un algorithme de FFT de taille spécifique.

Selon une autre particularité, les différents calculs de FFT sont pondérés par une fenêtre de Tchebychev, ladite fenêtre permettant le découpage en petits morceaux des signaux détectés qui ne résultent pas d'un calcul de FFT effectué avec la taille de FFT adaptée.

Selon une autre particularité, dans le calcul de FFT (E20) simultané, les différents seuils de détection de signaux et associés aux différentes tailles de FFT utilisées et rangées de manière croissante dans la mémoire, sont séparés d'une valeur constante comprise en 4dB et 10dB.

Selon une autre particularité, dans l'étape de sélection en temps réel de signaux (E21), l'exécution de l'algorithme de sélection permet de mettre en œuvre au moins une des étapes suivantes :
- délimitation d'une zone rectangulaire, autour de chaque signal du spectre détecté, obtenue pour chaque taille utilisée dans le calcul de FFT ;
- superposition desdites zones en prenant en compte les précisions temporelle et fréquentielle de chacune des tailles de FFT utilisées dans le calcul de FFT ;
- sélection par zone de signaux selon au moins un critère prédéfini mémorisé et relatif à la durée desdits signaux.

Selon une autre particularité, dans l'étape de sélection par zone, lorsqu'au moins deux zones de superposition se recouvrent, au moins une des étapes suivantes est mise en œuvre:
- comparaison de la durée des signaux présents dans chacune des zones, chaque durée étant comparée à un seuil mémorisé dépendant de la taille de FFT utilisée pour le calcul de FFT ;
- pour une taille de FFT donnée, si la durée d'un signal est supérieure à la valeur de seuil mémorisé correspondant à ladite taille choisie par le programme alors ledit signal est conservé puis mémorisé et les autres signaux, présents dans ces dites zones et correspondant à des tailles de FFT différentes, sont éliminés de la mémoire.

Selon une autre particularité, le procédé comprend également une étape (E3) d'assemblage des signaux sélectionnés par zones sur un même spectre pour constituer un spectre multi-FFT.

La présente invention a également pour but de proposer une infrastructure pour la détection de signaux ou impulsions radars.

Ce but est atteint par un système pour la détection de signaux radar comprenant au moins au moins un dispositif de numérisation de signaux radar, une architecture matérielle et informatique comportant au moins une mémoire pour l'enregistrement des signaux numérisées, ledit système étant caractérisé en ce que la mémoire mémorise également des tailles et des valeurs de seuil et l'architecture matérielle et informatique comprend également au moins un module de combinaison de signaux radar, au moins un processeur exécutant un programme stocké dans ladite mémoire pour mettre en œuvre les étapes du procédé de traitement de signaux radar.

Selon une autre particularité, le module de combinaison de signaux permet de regrouper l'ensemble des signaux détectés, via des calculs de FFT de tailles différentes, sur un même spectre.

### DESCRIPTION DES FIGURES ILLUSTRATIVES

D'autres particularités et avantages de la présente invention apparaîtront plus clairement à la lecture de la description ci-après, faite en référence aux dessins annexés, dans lesquels :

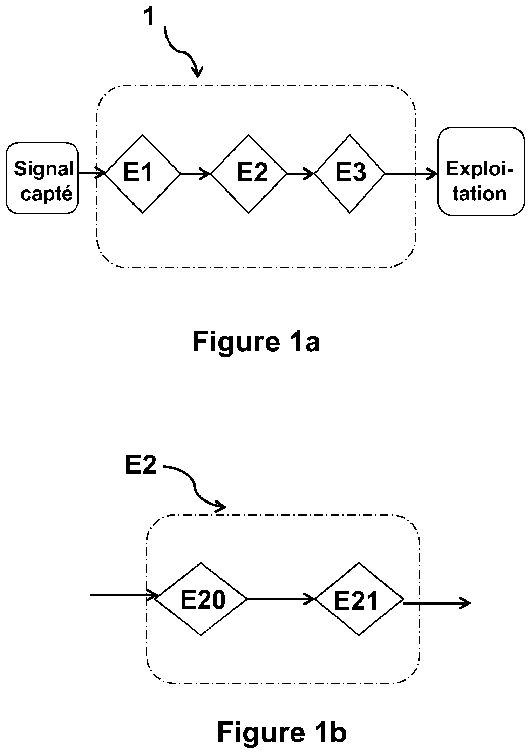

- les figures 1a et 1b représentent respectivement les différentes étapes du traitement de signaux radar et les sous-étapes de l'étape de génération de spectres, selon un mode de réalisation.

### DESCRIPTION DES MODES DE REALISATION PREFERES DE L'INVENTION

La présente invention concerne un procédé de traitement de signaux radar pour la détection d'objets.

Dans certains modes de réalisation, le procédé (1, figure 1a) de traitement de signaux radar dans un système de détection comprend au moins une architecture informatique comportant au moins une mémoire pour le stockage d'au moins un ensemble de programmes et/ou de données relatives signaux, au moins un processeur pour l'exécution desdits programmes afin de mettre en œuvre ledit procédé (1) comprenant au moins:
- une première étape (E1) de numérisation des signaux radar au moyen d'un dispositif de numérisation;
- une seconde étape (E2) de génération de spectres à partir des signaux numérisés, obtenus dans la première étape (E1), via un calcul FFT;
ledit procédé (1) étant caractérisé en ce que le calcul FFT de l'étape de génération de spectres (E2, figures 1a, 1b) comprend au moins un traitement multi-FFT comportant au moins:
- le calcul FFT (E20, figure 1b) simultané de différentes tailles avec sélection automatique desdites tailles;
- la sélection (E21, figure 1b) en temps réel de signaux détectés dans l'ensemble des spectres des différents calculs FFT via un algorithme de sélection.

La méthode ainsi décrite peut permettre au système de détection de s'auto-adapter à la nature hautement variable des différents paramètres d'un signal ou une impulsion radar. Les paramètres d'une impulsion radar comprennent au moins :
- la durée de l'impulsion ;
- la modulation (modulation linéaire de la fréquence) ;
- le niveau, et notamment les niveaux très faibles ;
- la juxtaposition fréquentielle d'impulsions entre elles ;
- la proximité temporelle d'impulsions entre elles.

Le radar est un système utilisant comme signaux ou impulsions analogiques des ondes radio, pour la détection et la détermination de la distance et/ou la vitesse d'objets ou de cibles tels que, par exemple, les voitures, les avions, les bateaux, etc. Le radar comprend en général, un dispositif émetteur qui envoie les signaux ou impulsions, qui sont réfléchi(e)s par l'objet ou la cible et un dispositif intercepteur ou récepteur qui capte ou reçoit lesdits signaux.

Le spectre électromagnétique utilisé par la plupart des radars d'intérêt est couvert par une bande de fréquences allant de 500 MHz à 18 GHz. Une antenne (ou plusieurs antennes adaptées à cette large bande), suivie d'un amplificateur et d'un récepteur permettent de produire un signal dit à fréquence intermédiaire (FI) qui représente une sous-bande de ce spectre total.

Après la réception, par ledit dispositif intercepteur, des signaux analogiques réfléchi(s), lesdits signaux sont transmis à un dispositif de numérisation, par exemple et de manière non limitative un analyseur de spectres numériques ou convertisseur analogique-numérique (CAN). Le passage d'un signal analogique, qui comporte un ensemble continu d'informations physiques pouvant prendre une infinité de valeurs différentes, à un signal numérique qui comporte un ensemble discret d'informations physiques avec un nombre fini de valeurs s'accompagnent en général d'une perte d'informations en fonction de la taille du calcul de FFT (Transformée de Fourier Rapide) utilisée pour analyser le signal.

En général, la méthode la utilisée pour détecter une impulsion radar consiste à appliquer la transformée de Fourier sur un signal radiofréquence numérisé. Le signal radiofréquence est le signal capté par une antenne, puis amplifié, puis transposé autour d'une FI (fréquence intermédiaire) et d'une largeur de bande données (par exemple 500 MHz).

La numérisation du signal radar passe d'abord, par l'échantillonnage dudit signal. L'échantillonnage consiste à prélever les valeurs d'un signal à intervalles définis et produit une suite de valeurs discrètes. La série de valeurs est ensuite utilisée pour le calcul de FFT afin d'obtenir un spectre de FFT du signal qui sera analysé pour l'interprétation des informations contenues dans ledit signal. Par taille du calcul de FFT, on entend le nombre de points utilisés dans l'échantillonnage du signal radar réfléchi.

Pour traiter une bande instantanée, le CAN doit avoir une fréquence d'échantillonnage d'au moins plus de 2 fois la bande passante (théorème de Shannon). Par exemple et de manière non limitative, pour traiter la bande instantanée de 500 MHz, la fréquence d'échantillonnage du CAN doit être d'environ 1.28 GHz.

En plus de la fréquence d'échantillonnage et/ou de la fenêtre temporelle d'analyse du signal ou fenêtre de pondération, qui sont des paramètres importants dans la numérisation et le calcul de FFT, la taille dudit calcul de FFT (nombre de points utilisés dans l'échantillonnage) joue également un rôle prépondérant dans l'obtention du spectre dudit signal et dans son interprétation. Le choix de la taille du calcul de FFT peut, en effet, influencer le processus de détection. Le radar émet, en général, des signaux à intervalles réguliers séparés d'une durée appelée «période de répétition des impulsions» (PRI). Son inverse est la «fréquence de répétition» (FR) ou «fréquence de récurrence». La «PRI» ou la «FR» détermine le fonctionnement global d'un radar et permet de distinguer plusieurs types de radars, par exemple les radars à basse fréquence de répétition (BFR) de 1 kHz à 10 kHz environ qui calculent la distance d'une cible à partir du retard des échos, et les radars à haute fréquence de répétition (HFR) de 100 kHz à 250 kHz environ qui détectent les cibles à partir de leurs vitesses plutôt qu'en exploitant leurs distances. Outre la PRI qui détermine le fonctionnement global d'un radar, la «largeur d'impulsion» (LI) permet de déterminer certaines des performances d'un radar, en particulier la bande passante et la résolution en distance. La LI est la durée pendant laquelle le radar émet une impulsion. La taille du calcul de FFT peut, ainsi, être adaptée ou non à la détection de certains types de signaux en fonction de la période de répétition des impulsions (PRI) et/ou de la largeur des impulsions (LI). Un signal ou une impulsion radar ayant, par exemple, une fréquence de répétition (FR) très courte nécessitera le choix d'un très grand nombre de points ou taille plus importante dans la phase d'échantillonnage du signal analogique, lors du traitement de FFT, à l'opposé d'un signal radar ayant une longue fréquence de répétition qui nécessitera le choix d'un plus petit nombre de points afin de décrire le signal, donc d'une petite taille. Si la taille ou le nombre de points choisis dans l'échantillonnage n'est pas adapté(e) à la description du signal radar, ce dernier peut ne pas être détecté. Les tailles utilisées sont, par exemple et de manière non limitative, 64, 128, 256, 512, 1024, 2048 et 4096. Par exemple et de manière non limitative, une taille de FFT de 64 points est adaptée à la détection des impulsions très courtes, et des impulsions très rapprochées en temps, ainsi que des impulsions à modulation chirp très rapide.

Par chirp, on entend une impulsion radar modulée linéairement en fréquence.

Le chirp est en général un signal complexe de la forme x(t) = a(t) exp{iϕ(t)}, où a(t) ≥ 0 est une amplitude passe-bas dont l'évolution est lente par rapport aux oscillations de la phase ϕ(t).

Une taille FFT de 1024 points est adaptée à la détection des impulsions très faibles (en énergie), et des impulsions simultanées en temps et rapprochées en fréquence. Enfin une taille FFT de 256 points est le compromis entre les deux précédentes.

En général, les 3 tailles FFT 64, 256 et 1024 sont les plus adaptées à couvrir l'ensemble des impulsions radar rencontrées, et dépendent bien évidemment également de la fréquence d'échantillonnage du CAN citée ci-dessus, soit 1.28 GHz. De préférence, on choisira les tailles 64, 256 et 1024 pour la détection des signaux ou impulsions radar.

En plus de la PRI et de la LI, d'autres paramètres peuvent être pris en compte dans le choix de la taille du calcul de FFT du signal radar, par exemple et de manière non limitative, la vitesse de variation de la fréquence de l'impulsion, le rapport signal à bruit, etc. En effet, une taille inadéquate peut induire du bruit dans le résultat du calcul de FFT du signal réfléchi, empêchant ainsi sa détection. La prise en compte automatique de plusieurs tailles dans le calcul de FFT avec la sélection des meilleurs signaux permet ainsi d'augmenter la probabilité de détection des signaux radar.

Le procédé de détection permet l'analyse en permanence et en temps réel d'une bande instantanée donnée, par exemple et de manière non limitative une bande instantanée de 500 MHz, pour y chercher la présence d'impulsions radar. Des transformées de Fourier (FFT) sont effectuées en temps réel et en continu sur ladite bande instantanée. La présence d'énergie en sortie des gammes de fréquence (« frequency bins » en anglais) de la FFT est alors pistée de FFT en FFT pour y détecter la présence d'impulsions radar. Une des difficultés consiste à choisir la bonne taille du calcul de FFT. En fait, il n'existe pas de taille unique pouvant permettre la capture de l'ensemble des impulsions radar. Le procédé de la présente invention permet de s'affranchir de cette contrainte.

Dans certains modes de réalisation, le calcul de FFT (E20) simultané de différentes tailles avec sélection automatique des tailles comprend l'exécution simultanée de différents sous-programmes comprenant chacun un algorithme de FFT de taille spécifique. Le traitement des signaux radar par calcul de FFT s'effectue, en général, avec un choix manuel de la taille d'échantillonnage.

Dans le traitement automatique, de la présente invention, le traitement ou calcul multi-FFT comprend au moins l'implémentation de plusieurs sous-programmes dans une architecture matérielle et informatique comprenant au moins un processeur et au moins une mémoire de stockage. De préférence, l'architecture matérielle est un FPGA (Field Programmable Gate Array), par exemple de type virtex 7 ou Ultrascale de Xilinx, qui est un circuit logique programmable multiprocesseur permettant l'implémentation simultanée ou en parallèle des calculs de FFT de différentes tailles. Les spectres de FFT issus des calculs sont ensuite stockés dans ladite mémoire de stockage. Chaque spectre obtenu est une représentation des amplitudes des différentes composantes spectrales du signal radar en fonction de la fréquence. Pour visualiser l'évolution du spectre en fonction du temps, l'on utilise un diagramme temps/fréquence, sur lequel chaque couleur utilisée pour le spectre indique l'intensité d'une composante spectrale. Le temps correspond à l'axe des abscisses et la fréquence à celui des ordonnées. A chaque intensité est associée une couleur différente.

Après l'obtention des spectres, l'algorithme de sélection est automatiquement exécuté, sur le processeur de l'architecture matérielle informatique, pour mettre en œuvre la sélection de composantes spectrales du signal radar.

Dans certains modes de réalisation, la fenêtre de pondération utilisée dans les différents calculs FFT est de préférence une fenêtre de Tchebychev, ladite fenêtre permettant le découpage en petits morceaux des signaux détectés qui ne résultent pas d'un calcul de FFT effectué avec la taille de FFT adaptée.

Dans certains modes de réalisation, avant la sélection des signaux ou impulsions radar détectés dans l'étape de calcul de FFT (E20) simultané, les différents seuils de détection de signaux, pour les différentes tailles de FFT utilisées et rangées de manière croissante, sont séparés d'une valeur constante comprise en 4dB et 10dB. De préférence on choisit une valeur constante égale à 6dB.

Ainsi, par exemple et de manière non limitative, le seuil de détection pour le calcul de FFT de taille T= 256 est réglé 6dB plus bas que celui de du calcul FFT de taille 64 et le seuil de détection pour le calcul FFT de taille T= 1024 est réglé 6dB plus bas que celui de du calcul FFT de taille 256.

A chaque taille est associé un seuil de détection différent, S pout T= 64 ; S -6dB pour T= 256 et S - 12dB pour T= 1024. L'ensemble des seuils associés aux tailles définies sont mémorisés puis utilisés par l'algorithme de détection.

Dans certains modes de réalisation, dans l'étape de sélection en temps réel de signaux (E21), l'exécution de l'algorithme de sélection permet de mettre en œuvre au moins la délimitation d'au moins une zone rectangulaire autour de chaque signal détecté du spectre obtenu pour chaque taille utilisée dans le calcul de FFT, et optionnellement :
- la superposition desdites zones en prenant en compte les précisions temporelles et fréquentielles de chacune des tailles de FFT utilisées dans le calcul de FFT ; et/ou
- la sélection de signaux zone par zone selon au moins un critère prédéfini mémorisé et relatif à la durée desdits signaux.

Dans certains modes de réalisation, dans l'étape de sélection par zone, lorsqu'au moins deux zones de superposition se recouvrent, au moins une des étapes suivantes est mise en œuvre:
- comparaison de la durée des signaux présents dans chacune des zones, chaque durée étant comparée à un seuil mémorisé dépendant de la taille de FFT utilisée pour le calcul FFT ;
- pour une taille de FFT donnée, si la durée d'un signal est supérieure à la valeur de seuil mémorisé correspondant à ladite taille alors ledit signal est conservé en mémoire et les autres signaux, présents dans ces dites zones et correspondant à des tailles de FFT différentes, sont éliminés de la mémoire.

Par exemple et de manière non limitative, la valeur seuil utilisée pour la sélection de signaux dans les différentes zones peut être la valeur LIₘᵢₙ minimale de la largeur d'impulsion LI. Ainsi l'algorithme lors de la sélection, par exemple et de manière non limitative, dans deux zones qui se recouvrent effectue les opérations suivantes:
- comparaison de la durée d'un signal avec chaque valeur LIₘᵢₙ des tailles de FFT utilisées (par exemple 64, 256 et 1024) et,
- si la durée d'un signal est supérieure à LIₘᵢₙ de la taille1024, alors ledit signal ou ladite impulsion conservé(e) est celui ou celle détecté(e) par le calcul de FFT de taille 1024, et tous les autres signaux détectés dans ces zones par les autres calculs de FFT de tailles différentes (256 et 64) sont éliminés de la mémoire,
- sinon, si la durée est supérieure à LIₘᵢₙ de la taille 256, alors l'impulsion conservé(e) est celle détecté par le calcul de FFT de taille 256, et tous les autres produits dans ces zones par la FFT 64 sont éliminés
- sinon, conservation des impulsions détectées par le calcul de FFT de taille 64.

La méthode de détection ainsi décrite permet également des bons résultats dans l'amélioration du pouvoir séparateur fréquentiel et du pouvoir séparateur temporel.

Le pouvoir séparateur fréquentiel est la capacité de séparation des impulsions rapprochées en fréquence. L'algorithme dans le cas d'impulsions rapprochées en fréquence va naturellement choisir la FFT de taille la plus grande en fonction de la durée des impulsions. Comme la FFT de taille la plus grande a le pouvoir séparateur fréquentiel le plus performant, le résultat final est donc optimal.

Le pouvoir séparateur temporel est la capacité de séparation des impulsions de même fréquence rapprochées en temps (le début de l'impulsion suivante est proche de l'impulsion précédente). Autrement dit en termes de radariste, la période de répétition des impulsions est petite. Or, les radars dont la PRI est faible sont des radars produisant des impulsions de durée très courtes. Et dans ce cas, le procédé de détection va automatiquement choisir la taille FFT la plus courte, soit la FFT 64 dans le cas de radar dit HFR (haute fréquence de répétition).

Dans certains modes de réalisation, le procédé comprend également une étape (E3) d'assemblage des signaux sélectionnés par zones sur un même spectre pour constituer un spectre multi-FFT.

Par spectre ou image spectrale ou image on entend une image issue de la décomposition d'une onde ou un signal après un traitement.

La présente invention concerne également un système pour la détection de signaux radar.

Dans certains modes de réalisation, le système pour la détection de signaux radar comprend au moins un dispositif de numérisation de signaux radar, une architecture matérielle et informatique comportant au moins une mémoire pour l'enregistrement des signaux numérisées, ledit système étant caractérisé en ce que l'architecture matérielle et informatique comprend également au moins un module de combinaison de signaux radar, au moins un processeur exécutant un programme stocké dans ladite mémoire pour mettre en œuvre les étapes du procédé (1) de traitement de signaux radar.

Le module de combinaison de signaux du système de détection de signaux radar permet de regrouper l'ensemble des signaux détectés, via des calculs de FFT de tailles différentes, sur un même spectre.

Par module, on entend un code exécutable par le processeur d'un dispositif informatique, par exemple un ordinateur.

La présente demande décrit diverses caractéristiques techniques et avantages en référence aux figures et/ou à divers modes de réalisation. L'homme de métier comprendra que les caractéristiques techniques d'un mode de réalisation donné peuvent en fait être combinées avec des caractéristiques d'un autre mode de réalisation à moins que l'inverse ne soit explicitement mentionné ou qu'il ne soit évident que ces caractéristiques sont incompatibles ou que la combinaison ne fournisse pas une solution à au moins un des problèmes techniques mentionnés dans la présente demande. De plus, les caractéristiques techniques décrites dans un mode de réalisation donné peuvent être isolées des autres caractéristiques de ce mode à moins que l'inverse ne soit explicitement mentionné.

Il doit être évident pour les personnes versées dans l'art que la présente invention permet des modes de réalisation sous de nombreuses autres formes spécifiques sans l'éloigner du domaine d'application de l'invention comme revendiqué. Par conséquent, les présents modes de réalisation doivent être considérés à titre d'illustration, mais peuvent être modifiés dans le domaine défini par la protection demandée, et l'invention ne doit pas être limitée aux détails donnés ci-dessus.

## Revendications

1. Procédé (1) de traitement de signaux radar dans un système de détection comprenant au moins une architecture informatique comportant au moins une mémoire pour le stockage d'au moins un ensemble de programmes et/ou de données relatives aux signaux, au moins un processeur pour l'exécution desdits programmes afin de mettre en œuvre ledit procédé (1) comprenant au moins:
• une première étape (E1) de numérisation des signaux radar au moyen d'un dispositif de numérisation;
• une seconde étape (E2) de génération de spectres à partir des signaux numérisés, obtenus dans la première étape (E1), via un calcul de la transformée de Fourier rapide, FFT, ledit calcul de FFT comprenant au moins un traitement multi-FFT comportant au moins le calcul de FFT (E20) simultané comprenant différents calculs de FFT de différentes tailles de FFT avec sélection automatique desdites tailles via un algorithme de sélection parmi les tailles mémorisées;
ledit procédé (1) étant tel que:
- le traitement multi-FFT comprend la sélection en temps réel de signaux (E21) dans l'ensemble des spectres résultants des différents calculs de FFT, effectuée via un algorithme de sélection.
- dans le calcul de FFT (E20) simultané, les différents seuils de détection de signaux pour les différentes tailles de FFT utilisées et rangées de manière croissante dans la mémoire, sont séparés d'une valeur constante comprise entre 4dB et 10dB.

2. Procédé (1) de traitement de signaux radar selon la revendication 1, **caractérisé en ce que** le calcul de FFT (E20) de différentes tailles avec sélection automatique des tailles comprenant l'exécution simultanée de différents sous-programmes comportant chacun un algorithme de FFT de taille spécifique.

3. Procédé (1) selon les revendications 1 et 2, **caractérisé en ce que** les différents calculs de FFT sont pondérés par une fenêtre de Tchebychev, ladite fenêtre permettant le découpage en petits morceaux des signaux détectés qui ne résultent pas d'un calcul de FFT effectué avec la taille de FFT adaptée.

4. Procédé (1) selon la revendication 1, **caractérisé en ce que** dans l'étape de sélection en temps réel de signaux (E21), l'exécution de l'algorithme de sélection permet de mettre en œuvre au moins la délimitation d'au moins une zone rectangulaire autour de chaque signal du spectre détecté obtenu pour chaque taille utilisée dans le calcul de FFT, et optionnellement :
• la superposition desdites zones en prenant en compte les précisions temporelle et fréquentielle de chacune des tailles de FFT utilisées dans le calcul de FFT ;
et/ou
• la sélection de signaux zone par zone selon au moins un critère prédéfini mémorisé et relatif à la durée desdits signaux.

5. Procédé (1) selon la revendication 4, **caractérisé en ce que**
dans l'étape de sélection par zone, lorsqu'au moins deux zones de superposition se recouvrent, au moins une des étapes suivantes est mise en œuvre:
• comparaison de la durée des signaux présents dans chacune des zones, chaque durée étant comparée à un seuil mémorisé dépendant de la taille de FFT utilisée pour le calcul de FFT ;
• pour une taille de FFT donnée, si la durée d'un signal est supérieure à la valeur de seuil mémorisé correspondant à ladite taille choisie par le programme alors ledit signal est conservé puis mémorisé et les autres signaux, présents dans ces dites zones et correspondant à des tailles de FFT différentes, sont éliminés.

6. Procédé (1) de traitement de signaux radar selon les revendications 1 à 5, **caractérisé en ce que** le procédé comprend également une étape (E3) d'assemblage des signaux sélectionnés par zones sur un même spectre pour constituer un spectre multi-FFT.

7. Système pour la détection de signaux radar comprenant au moins un dispositif de numérisation de signaux radar, une architecture matérielle et informatique comportant au moins une mémoire pour l'enregistrement des signaux numérisés, ledit système étant **caractérisé en ce que** la mémoire mémorise également des tailles et des valeurs de seuil et l'architecture matérielle et informatique comprend également au moins un module de combinaison de signaux radar, au moins un processeur exécutant un programme stocké dans ladite mémoire pour mettre en œuvre les étapes du procédé (1) de traitement de signaux radar selon l'une des revendications à 6.

8. Système selon la revendication 7, **caractérisé en ce que** le module de combinaison de signaux permet de regrouper l'ensemble des signaux détectés, via des calculs de FFT de tailles différentes, sur un même spectre.

## Patentansprüche

1. Verfahren (1) zum Verarbeiten von Radarsignalen in einem Detektionssystem mit mindestens einer Rechnerarchitektur, die mindestens einen Speicher zum Speichern mindestens eines Satzes von Programmen und/oder Daten bezüglich der Signale, mindestens einen Prozessor zur Ausführung der Programme umfasst, um das Verfahren (1) zu implementieren, umfassend mindestens:
• einen ersten Schritt (E1) der Digitalisierung der Radarsignale unter Verwendung einer Digitalisierungsvorrichtung;
• einen zweiten Schritt (E2) der Erzeugung von Spektren aus den digitalisierten Signalen, die in dem ersten Schritt (E1) erhalten wurden, über eine Berechnung der schnellen Fourier-Transformation, FFT, wobei die FFT-Berechnung mindestens eine Multi-FFT-Verarbeitung umfasst, die mindestens die gleichzeitige FFT-Berechnung (E20) umfasst, die verschiedene FFT-Berechnungen von unterschiedlichen FFT-Größen mit automatischer Auswahl der Größen über einen Auswahlalgorithmus unter den gespeicherten Größen umfasst;
wobei das Verfahren (1) so ist, dass:
- die Multi-FFT-Verarbeitung die Echtzeitauswahl von Signalen (E21) aus allen Spektren umfasst, die sich aus den verschiedenen FFT-Berechnungen ergeben, welche über einen Auswahlalgorithmus durchgeführt wird,
- bei der gleichzeitigen FFT-Berechnung (E20) die unterschiedlichen Signalerkennungsschwellen für die verwendeten und ansteigend in dem Speicher abgelegten unterschiedlichen FFT-Größen durch einen konstanten Wert zwischen 4 dB und 10 dB getrennt sind.

2. Verfahren (1) zur Verarbeitung von Radarsignalen nach Anspruch 1, **dadurch gekennzeichnet, dass** die FFT-Berechnung (E20) unterschiedlicher Größen mit automatischer Auswahl der Größen die gleichzeitige Ausführung verschiedener Unterprogramme umfasst, die jeweils einen FFT-Algorithmus bestimmter Größe umfassen.

3. Verfahren (1) nach den Ansprüchen 1 und 2, **dadurch gekennzeichnet, dass** die verschiedenen FFT-Berechnungen durch ein Tschebyscheff-Fenster gewichtet werden, wobei das Fenster die Aufteilung der erfassten Signale in kleine Stücke ermöglicht, die nicht aus einer FFT-Berechnung mit der geeigneten FFT-Größe resultieren.

4. Verfahren (1) nach Anspruch 1, **dadurch gekennzeichnet, dass** in dem Schritt der Echtzeitauswahl von Signalen (E21) die Ausführung des Auswahlalgorithmus ermöglicht, mindestens die Abgrenzung mindestens eines rechteckigen Bereichs um jedes Signal des erfassten Spektrums herum zu implementieren, das für jede Größe erhalten wurde, die bei der FFT-Berechnung verwendet wird, und gegebenenfalls:
• die Überlagerung dieser Bereiche unter Berücksichtigung der Zeit- und Frequenzgenauigkeiten jeder der bei der FFT-Berechnung verwendeten FFT-Größen;
und/oder
• die bereichsweise Auswahl von Signalen nach mindestens einem gespeicherten vordefinierten Kriterium bezüglich der Dauer der Signale.

5. Verfahren (1) nach Anspruch 4, **dadurch gekennzeichnet, dass** im Schritt der Bereichsauswahl, wenn mindestens zwei überlappende Zonen übereinstimmen, mindestens einer der folgenden Schritte ausgeführt wird:
• Vergleich der Dauer der in jedem der Bereiche vorhandenen Signale, wobei jede Dauer mit einem gespeicherten Schwellenwert in Abhängigkeit von der Größe der FFT, die für die FFT-Berechnung verwendet wird, verglichen wird;
• für eine gegebene FFT-Größe, wenn die Dauer eines Signals länger ist als der gespeicherte Schwellenwert, welcher der von dem Programm gewählten Größe entspricht, das Signal dann behalten und anschließend gespeichert wird, und die anderen Signale, die in diesen Bereichen vorhanden sind und unterschiedlichen FFT-Größen entsprechen, gelöscht werden.

6. Verfahren (1) zum Verarbeiten von Radarsignalen nach den Ansprüchen 1 bis 5, **dadurch gekennzeichnet, dass** das Verfahren auch einen Schritt (E3) des Zusammensetzens der Signale umfasst, die bereichsweise auf demselben Spektrum ausgewählt werden, um ein Multi-FFT-Spektrum zu bilden.

7. System zur Detektion von Radarsignalen, umfassend mindestens eine Vorrichtung zum Digitalisieren von Radarsignalen, eine Hardware- und Rechnerarchitektur mit mindestens einem Speicher zum Aufzeichnen der digitalisierten Signale, wobei das System **dadurch gekennzeichnet ist, dass** der Speicher auch Größen und Schwellenwerte speichert und die Hardware- und Rechnerarchitektur auch mindestens ein Modul zum Kombinieren von Radarsignalen und mindestens einen Prozessor umfasst, der ein in dem Speicher gespeichertes Programm ausführt, um die Schritte des Verfahrens (1) zum Verarbeiten von Radarsignalen nach einem der Ansprüche 1 bis 6 auszuführen.

8. System nach Anspruch 7, **dadurch gekennzeichnet, dass** das Modul zum Kombinieren von Radarsignalen ermöglicht, alle erfassten Signale durch FFT-Berechnungen unterschiedlicher Größe in demselben Spektrum zusammenzufassen.

## Claims

1. Method (1) for processing radar signals in a detection system comprising at least a computing architecture including at least one memory to store at least one set of signal-related programs and/or data, at least one processor executing said programs to implement said method (1) comprising at least:
- a first step (E1) to digitize radar signals by means of a digitization device;
- a second step (E2) to generate spectra from the digitized signals obtained at the first step (E1), via Fast Fourier Transformation, FFT, computation, said FFT computation comprises at least a multi-FFT processing comprising at least simultaneous FFT computation (E20) comprising different FFT computations of different sizes of FFT with automatic selection of said sizes via a selection algorithm from among the stored;
said method (1) being such that:
- the multi-FFT processing comprises real-time selection of signals (E21) in all spectra resulting from the different FFT computations, performed via a selection algorithm,
- in the simultaneous FFT computation (E20), the different signal detection thresholds associated with the different FFT sizes used and placed in increasing order in the memory, are separated by a constant value of between 4dB and 10dB.

2. The method (1) for processing radar signals according to claim 1, **characterized in that** FFT computation (E20) of different sizes with automatic size selection comprises the simultaneous execution of different sub-programs each comprising an FFT algorithm of specific size.

3. The method (1) according to claims 1 and 2, **characterized in that** the different FFT computations are weighted by a Chebyshev window, said window allowing the breakdown into small parts of detected signals which do not result from an FFT computation performed with the adapted FFT size.

4. The method (1) according to claim 1, **characterized in that** at the real-time signal selection step (E21), execution of the selection algorithm allows implementation of at least the delimiting of at least one rectangular zone around each detected signal of the spectrum obtained for each size used in FFT computation,
and optionally:
• superimposing said zones taking into account the time and frequency details of each of the FFT sizes used in FFT computation; and/or
• selecting signals zone-by-zone in accordance with at least one memorized, predefined criterion relating to the duration of said signals.

5. The method (1) according to claim 4, **characterized in that** at the selection step per zone, if at least two superimposed zones overlap, at least one of the following steps is carried out:
- comparing the duration of the signals contained in each of the zones, each duration being compared with a memorized threshold dependent upon the FFT size used for FFT computation;
- for a given FFT size, if the duration of a signal is greater than the memorized threshold value corresponding to said size selected by the program, then said signal is retained and memorized and the other signals contained in these said zones and corresponding to different FFT sizes are removed.

6. The method (1) for processing radar signals according to claims 1 to 5, **characterized in that** the method also comprises a step (E3) to group together signals selected per zone on one same spectrum, to form a multi-FFT spectrum.

7. System for detecting radar signals comprising at least one radar signal digitization device, a computing and hardware architecture comprising at least one memory to record digitized signals, said system being **characterized in that** the memory also memorizes sizes and threshold values, and the computing and hardware architecture also comprises at least one radar signal combining module, at least one processor executing a program stored in said memory to implement the steps of the method (1) for processing radar signals according to one of claims 1 to 6.

8. The system according to claim 7, **characterized in that** the signal combining module allows the grouping together of all detected signals, via FFT computations of different sizes, on one same spectrum.
